# EUROPEAN PATENT APPLICATION

(11) **EP 3 843 130 A1**
(43) Date of publication of application: **30.06.2021**
(21) Application number: 19219343.1
(22) Date of filing: 23.12.2019
(51) Int. Cl.: H01L 21/768

(54) **A METHOD FOR FORMING AN INTERCONNECTION STRUCTURE**

(71) Applicant: Imec VZW, 3001 Leuven (BE)
(72) Inventor: O´TOOLE, Martin, 3001 Leuven (BE); WILSON, Christopher, 3001 Leuven (BE); TOKEI, Zsolt, 3001 Leuven (BE); MURDOCH, Gayle, 3001 Leuven (BE)
(74) Representative: AWA Sweden AB

(57) **Abstract**

According to an aspect of the present inventive concept there is provided a method for forming an interconnection structure for a semiconductor device, the method comprising:
forming, over a conductive layer, an alternating pattern of parallel material lines of a first set of material lines of a first material and of a second set of material lines of a second material, the material lines being spaced apart by gaps,
patterning the conductive layer, the patterning comprising etching while using the alternating pattern of material lines as an etch mask, thereby forming a set of parallel conductive lines spaced apart by gaps and capped by the alternating pattern of material lines (thus defining a set of capped conductive lines),
depositing an insulating material different from the first and second materials between the set of capped conductive lines, and
forming a via hole mask defining an opening above a selected material line of either the first or second set of material lines,
forming a via hole exposing the conductive line capped by said selected material line, the forming of the via hole comprising selectively etching said selected material line through the opening in the via hole mask, and
depositing a conductive material in the via hole to form a conductive via on said conductive line capped by said selected material line.

## Description

### Technical field

The present inventive concept relates to a method for forming an interconnection structure.

### Background

Integrated circuit fabrication frequently employ processes for forming electrical interconnection structures for interconnecting semiconductor devices in a functioning circuit. An interconnection structure may include one or more interconnection levels or metallization levels, which are formed above the active device layer (i.e. the front-end-of-line, FEOL). An interconnection level includes horizontal conductive paths or lines arranged in an insulating material layer. Lines of different interconnection levels may be interconnected by conductive vias extending vertically through the insulating layers.

An established approach for forming interconnection levels is the dual-damascene approach. According to the dual-damascene approach, trenches and via holes are patterned in an insulating layer and filled with a conductive material, typically metal, to form lines in the trenches and vias in the via holes. The process may be repeated to form a stack of interconnection levels. The trench patterning typically relies on multiple patterning techniques like (litho-etch)^{x}, or pitch splitting techniques such as self-aligned double patterning (SADP) or quadruple patterning (SAQP), to enable dense line patterns with sub-lithographic critical dimensions.

An alternative approach gaining increasing attention is to directly "print" lines in a metal layer. In contrast to the dual-damascene approach where lines are formed by filling trenches with metal, metal line printing involves patterning lines in a metal layer (e.g. Ru). According to one technique involving metal line printing (which sometimes is referred to as semi-damascene processing) via holes patterned (by a litho-etch) are formed in an insulating layer and then overfilled with metal such that a metal layer is formed over the insulating layer. Lines may then be patterned in the metal layer over the metal filled via holes. Combined with multiple patterning techniques such as SADP or SAQP for the metal line patterning, metal line printing offers a way towards even more aggressive line pitches.

However, as the line pitches decrease so does the margin for errors during via litho. As the line pitches decrease the risk of a via hole unintentionally overlapping a metal line adjacent to the target metal line is increased. Such an overlap may result in the via shorting the adjacent metal lines.

### Summary

An objective of the present inventive concept is thus to provide a method allowing forming of interconnection structures comprising tight-pitch conductive lines and vias connecting thereto, while mitigating the aforementioned risk. Further and alternative objectives may be understood from the following.

According to an aspect of the present inventive concept there is provided a method for forming an interconnection structure for (i.e. suitable for) a semiconductor device, the method comprising:
forming, over a conductive layer, an alternating pattern of parallel material lines of a first set of material lines of a first material and of a second set of material lines of a second material, the material lines being spaced apart by gaps,
patterning the conductive layer, the patterning comprising etching while using the alternating pattern of material lines as an etch mask, thereby forming a set of parallel conductive lines spaced apart by gaps and capped by the alternating pattern of material lines (thus defining a set of capped conductive lines),
depositing an insulating material different from the first and second materials between the set of capped conductive lines, and
forming a via hole mask defining an opening above a selected material line of either the first or second set of material lines,
forming a via hole exposing the conductive line capped by said selected material line, the forming of the via hole comprising selectively etching said selected material line through the opening in the via hole mask, and
depositing a conductive material in the via hole to form a conductive via on said conductive line capped by said selected material line.

According to the inventive method, the alternating pattern of material lines has the double function of acting as an etch mask while forming the conductive lines (i.e. allowing conductive lines to be directly "printed" in the conductive layer), and subsequently during via hole formation act as an etch stop over conductive lines capped by material lines adjacent to the selected material line. This double function is enabled by keeping the material lines as capping on the conductive lines also during the via hole formation.

If the via hole is formed to (unintentionally) overlap also a material line adjacent to the selected line, the adjacent material line may act as an etch stop above the underlying conductive line, and hence ensure that it is not exposed in the via hole. Due to the alternating pattern of material lines, the material lines are alternatingly of the first material and the second material. This provides etch contrast allowing selective etching of either the first material line or the second material line. That is the first material line may be etched selectively with respect to the second material line which may act as an etch stop/etch mask, and vice versa. As the insulating material is different from each of the first and second materials, the first (or second) material line may be etched selectively with respect to both the second (or first) material line and the insulating material.

By a selective etching of a first feature (of a given material) is hereby meant that the first feature is etched at a greater rate than a second feature (of a different material) also exposed to the etching. Thereby, said given material (forming the first feature) may be selectively removed, i.e. removed at a greater rate than said different material (forming the second feature).

Correspondingly, a first feature acting/being used as an etch mask during etching of second feature (such as a layer) implies that the first feature is (at least partially) preserved when the etching of the second feature is stopped/complete such that a pattern defined by the first feature (e.g. one or more openings) may be "transferred" to the second feature by the etching thereof.

By depositing the insulating material between the capped conductive lines, insulating material may be provided on either side of the material lines of the alternating pattern of material lines. Thus, the material lines of the alternating pattern of material lines may be spaced apart by the deposited insulating material (e.g. forming insulating lines in spaces between the material lines). Denoting the first material lines "A", the second material lines "B" and the insulating material "C", a repetitive "three-tone pattern" of "ACBC" may hence form after the insulating material deposition.

An intermediate layer structure of one or more layers may be formed on the conductive layer, wherein the alternating pattern of material lines may be formed on an upper surface of the intermediate layer structure. Accordingly, the patterning of the conductive layer may comprise first etching the intermediate layer structure and then etching the conductive layer. Hence, after the patterning of the conductive layer each conductive line thus formed may be capped by a respective stack of lines, each comprising one or more intermediate lines (formed by the etching of the intermediate layer structure) and a material line of the alternating pattern of material lines. Moreover, the forming of the via hole may comprise first etching the selected material line and then etching the intermediate layer structure.

The method may further comprise:
forming spacer lines on and along sidewalls of the first material lines, wherein forming the second material lines comprises depositing the second material in gaps between the spacer lines, and
subsequent to forming the second material lines, removing the spacer lines between the first and second material lines. Thereby gaps may be formed between the first and second material lines. If the alternating pattern of material lines as set out above are formed on an upper surface of an intermediate layer structure, the upper surface may be exposed in the gaps between the material lines. The line width of the gaps (i.e. the separation between the first and second lines) may be determined by the line width of the spacer lines.

Forming the first set of material lines may comprise:
forming a first material layer,
forming a set of mandrel lines over the first material layer, and
patterning the first material layer to form the first set of material lines, the patterning comprising etching while using the set of mandrel lines as an etch mask.

Spacer lines may be formed subsequent to patterning the first material layer, on and along sidewalls of the first material lines and the mandrel lines.

The method may further comprise removing the set of mandrels prior to depositing the insulting material, and preferably prior to patterning the conductive layer. This allows limiting the height of the via, which otherwise would need to bridge the additional height of the mandrels.

The insulating material may be deposited to (completely) cover the first and second material lines, and the method may further comprise, by a polishing process and/or etch back, forming an insulting layer with a planar upper surface flush with upper surfaces of the first and second material lines.

The method may further comprise depositing a conductive material to form a second conductive layer, the conductive material covering the insulating layer and filling the via hole. By overfilling the via hole, a via may be formed and a conductive layer may be provided which subsequently may be patterned to form further conductive lines, e.g. of a consecutive/higher interconnection level.

The opening in the via hole mask may, in addition to overlapping the selected material line, further extend above (and thus overlap) the deposited insulating material in a region adjacent to the selected material line. For example, a lateral dimension of the opening may exceed a line width of the selected material line.

The opening in the via hole mask may further extend above (and thus overlap) a material line of the alternating pattern of material lines consecutive to the selected material line. For example, a lateral dimension of the opening may exceed a sum of a line width of the selected material line and a (line) width of a gap/spacing between the first and second material lines.

The opening in the via hole mask may further extend above (and thus overlap) three or more consecutive material lines of the alternating pattern of material lines. Hence, via holes may be formed above two (or more) first material lines or second material lines by etching through a same opening.

According to embodiments, the method may further comprise, prior to patterning the conductive layer, cutting at least a first material line or a second material line into two line segments separated by a gap by selectively etching a selected material line (which may be a same material line as the aforementioned "selected material line", or a further material line other than the aforementioned "selected material line"). That is, if the material line selected for cutting is of the first set of material lines, the etch may etch the first material selective to the second material and the spacer material. Conversely, if the material line selected for cutting is of the second set of material lines, the etch may etch the second material selective to the first material and the spacer material.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.

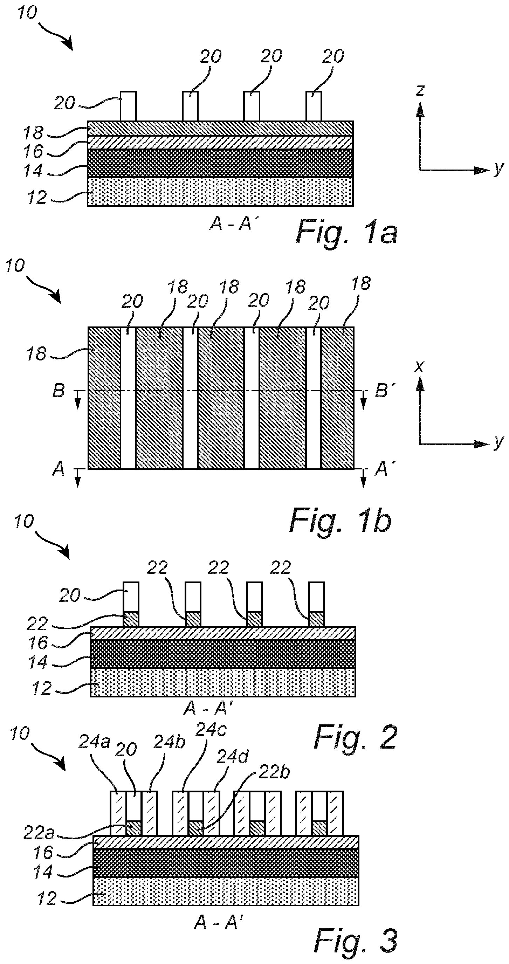

Figures 1-12 illustrate a method for forming an interconnection structure.

### Detailed description

A method for forming an interconnection structure, suitable for instance for a semiconductor device, will now be described with reference to Figures 1-12.

Figure 1a shows a cross section of a part of a structure 10 along the line A-A' indicated in the top-down view depicted in figure 1b. The structure 10 represents a starting structure for the method and may for instance be an intermediate product semiconductor device. The structure 10 may extend laterally or horizontally beyond the illustrated part. The illustrated planes of section extending through the structure are common to all the figures unless stated otherwise. It is noted that the relative dimensions of the shown elements, in particular the relative thickness of the layers, is merely schematic and may, for the purpose of illustrational clarity, differ from a physical structure. In the figures, directions x and y indicates a first and a second horizontal direction, respectively, and z indicates a vertical direction. Directional qualifiers such as "horizontal" and "vertical" should hereby be understood in relation to a local frame of reference of the structure 10. More specifically, a horizontal direction or orientation may be understood as a direction or orientation parallel to main plane of extension of a planar layer of the structure 10, such as of the conductive layer 14 discussed below. Correspondingly, a vertical direction or orientation may be understood as a direction or orientation normal to the main plane of extension of the conductive layer 14. As may be appreciated, the horizontal and vertical directions may equivalently be related to a main plane of extension of a substrate of the structure 10. As may be appreciated, terms such as "over", "above", "below", "upper", "underlying", "top" should be understood as relative positions as viewed along a vertical direction.

The structure 10 comprises a conductive layer 14 formed over a (first) insulating layer 12. The conductive layer 14 may be formed on an upper surface of the insulating layer 12. It is also possible to form an interfacial layer, such as an adhesion layer (e.g. of TiN), on the insulating layer 12 and then form the conductive layer 14 on the interfacial layer. The insulating layer 12 may be of an oxide, such as silicon oxide. Also other materials are possible such as any conventional (low-k) inter-layer dielectric (ILD) material, for instance spin-on-glass or spin-on-carbon. The insulating layer 12 may be formed over (not shown) conductive structures, such as conductive lines of a lower interconnection level, or contact structures for devices, such as source/drain or gate contacts of semiconductor devices. The conductive layer 14 may be a metal layer, for instance a layer of ruthenium (Ru). Other examples of conductive layer materials include a layer of molybdenum (Mo), aluminum (Al), tungsten (W), iridium (Ir), copper (Cu), cobalt (Co), titanium (Ti), gold (Au), silver (Ag) or nickel (Ni). The conductive layer 14 may be deposited by chemical vapor deposition (CVD) or atomic layer deposition (ALD). Physical vapor deposition (PVD) or electroplating are also possible deposition techniques for the conductive layer 14. The conductive layer 14 is to be patterned to form conductive lines. Hence, a thickness of the conductive layer 14 may match a desired height of the conductive lines which are to be formed.

Although not shown, the structure 10 may further comprise an underlying substrate 10 supporting the insulating layer 12 and the conductive layer 14 etc. The substrate 10 may for instance be a semiconductor substrate such as a silicon (Si) substrate, a silicon-on-insulator (SOI) substrate, a germanium (Ge) substrate, a SiGe substrate etc. or any other conventional substrate selected in accordance with the type of circuit to be formed. By way of example, an active device layer including semiconductor devices such as transistors may be fabricated on a main surface of the substrate. The active device layer may also be referred to as a front-end-of-line portion (FEOL-portion). The insulating layer 12 may as an example form an ILD over the active device level.

An intermediate layer structure 16 is formed on the conductive layer 14. A first material layer 18 is formed on the intermediate layer structure 16. The first material layer 18 is to be patterned to form a first set of material or mask lines 22. The first set of material lines 22 are further to be used for patterning the conductive layer 14, among others. Meanwhile, the intermediate layer structure 16 may be formed of a single layer or a stack of two or more layers. The composition of the intermediate layer structure 16 may be chosen e.g. to facilitate patterning of the first material layer 18 (e.g. by comprising a top layer serving as an etch stop during patterning of the first material layer 18); and/or to facilitate formation of the first material layer 18 (e.g. by comprising a top layer serving as an adhesion layer for the first material layer 18). The intermediate layer structure 16 may also comprise a lower protective or interfacial layer on the conductive layer 14 to protect the conductive layer 14 until it is to be etched.

The first material layer 18, and thus the first set of material lines 22, is formed of a first material. For example, the first material may be a hard mask material wherein the first material layer 18 and the first set of material lines 22 may be hard mask layer and hard mask, respectively. The first material may for example be a nitride, an oxide or an organic film. Non-limiting examples include SiN, TiN, AlN, SiO₂, TiOₓ, AlOₓ, AlON, SiOC, SiCN, a TEOS oxide, an FTEOS oxide, a carbon-comprising film such as a-C. The first material layer 18 may be deposited using any conventional deposition technique suitable for the material, including ALD, CVD and spin-on-deposition techniques.

The intermediate layer structure 16 may for example comprise any of the materials listed in connection with the first material, albeit preferably of a different material than the material selected as the first material, either as a top-most layer or as an only layer if the intermediate layer structure 16 is formed by a single layer. In other words, a material forming the upper surface of intermediate layer structure 16 should preferably be different from the first material. As a non-limiting example, if the first material is SiN the intermediate layer structure 16 may comprise a TiN-layer on which the SiN-layer is formed, or a layer stack of TiN/SiN/TiN, on which the SiN-layer is formed. In either case, the TiN-layer may serve as a combined adhesion- and etch stop layer below the SiN-layer. As a further example, the intermediate layer structure 16 may comprise a layer of a material A, or a stack of layers of materials A/B/A, where A is selected as TiN, AlN, AlON, SiCN or WCₓ and B is selected as SiN, SiON or SiO₂.

As further shown in figures 1a, 1b a set of mandrel lines 20 have been formed on the first material layer 18. The set of mandrel lines 20 is formed as a set of parallel lines extending along the x-direction, regularly spaced apart by gaps. The first material layer 18 may hence be exposed in the gaps between mandrel lines 20. The mandrel lines 20 may for example be formed of a-Si, poly-Si, or some other suitable material which may provide an etch contrast with respect to the first material such that the mandrel lines 20 may act as an etch mask during etching of the first material layer 18. The mandrel lines 20 may for instance be formed by depositing a mandrel material layer (e.g. of a-Si or poly-Si) and subsequently patterning the same in a lithography and etching process (a "litho-etch" process).

A litho-etch sequence may as per se is known in the art generally comprise forming a photoresist mask layer on the layer which will be patterned, i.e. "the target layer" (such as the mandrel layer). A pattern (e.g. a pattern of openings, trenches or lines, depending on the pattern intended) may be lithographically defined in the photoresist layer and then transferred into the target layer by etching while using the patterned photoresist layer as an etch mask. The photoresist layer may thereafter be stripped from the target layer. In a more elaborate approach, a litho-etch sequence may, rather than a single photoresist mask, comprise forming a lithographic mask layer stack (a "litho-stack") on the target layer. The litho-stack may comprise a patterning layer as a lower layer of the litho-stack. The patterning layer may be an amorphous-carbon film, or some other conventional organic or non-organic patterning film allowing high-fidelity pattern transfer into the target layer. The litho-stack may further comprise a photoresist layer and a set of transfer layers intermediate the patterning layer and the photoresist layer. The set of intermediate layers may comprise, for instance, one or more anti-reflective coatings such as SiOC layers, spin-on-glass layers and optionally a planarization layer such as an organic spin-on layer (e.g. spin-on-carbon). A pattern may be lithographically defined in the photoresist layer and subsequently transferred into lower layers of the litho-stack, in a number of etch steps, and subsequently into the patterning layer. The pattern transfer process may cause a partial consumption of the litho-stack. For instance, the photoresist layer may be consumed during the transfer process. The litho-etch sequence may conclude by etching the target layer while using (at least) the patterned patterning layer as an etch mask. Any remaining layers of the litho-stack may thereafter be stripped from the target layer.

Figure 2 shows that the first material layer 18 has been patterned to form the first set of material lines 22 (hereinafter "first material lines 22") by etching the first material layer 18 while using the set of mandrel lines 20 as an etch mask. The first material layer 18 may be etched using an etching process which removes the first material from the non-masked areas of the first material layer 18 exposed between the mandrel lines 20. The etching may as shown be stopped on an upper surface of the intermediate layer structure 16. For instance, a dry etching process such as reactive ion etching (RIE) or ion beam etching (IBE) may be used. Accordingly, the first material lines 22 may (like the mandrel lines 20) be formed as a set of parallel material lines extending along the X-direction and regularly spaced apart by gaps. An upper surface of the intermediate layer structure 16 may hence be exposed in the gaps between the first material lines 22.

As an alternative to the above-described, the first set of material lines 22 may instead of being formed by etching using mandrel lines 20 as an etch mask more generally be formed using other multiple patterning techniques such as (litho-etch)x, SADP or SAQP. Extreme ultraviolet lithography (EUVL) may also be used to define a tight pitch pattern in a photoresist layer which subsequently may be used to etch the first material layer 18 to form the first material lines 22.

With reference to figure 3, a (sacrificial) set of spacer lines or sidewall spacers 24 (hereinafter "spacer lines 24") have been formed on and along the sidewalls of the first material lines 22. If the mandrel lines 20 remain on the first material lines 22 the spacer lines 24 may as shown form also on and along the sidewalls of the mandrel lines 20. However, it is contemplated that the mandrel lines 20 also may be removed after the first material lines 22 have been formed and prior to forming the spacer lines 24. In the following, one or more letters such as "a", "b" etc. may be appended to the reference signs to designate particular lines among the set of material/spacer/conductive lines, etc. or parts/segments thereof.

As exemplified for the first material lines 22a and 22b a pair of spacer lines 24a, 24b and 24c, 24d have been formed on opposite sidewalls of each first material line 22. The spacer lines 24 are formed with a thickness such that a gap remains between spacer lines 24 formed on consecutive pairs of the first material lines 22 (c.f. e.g. gap between spacer lines 24b and 24c of the consecutive first material lines 22a, 22b). Accordingly, an upper surface of the intermediate layer structure 16 may be exposed in the gaps between the spacer lines 24 (which has been reduced compared to prior to the formation of the spacer lines 24).

The spacer lines 24 may be formed using a sidewall spacer deposition process. A sidewall spacer deposition process may comprise depositing a conformal spacer layer of a spacer material, e.g. an ALD layer - which may be formed with a uniform (or at least substantially uniform) thickness. The spacer layer may be deposited to completely cover the structure 10, i.e. exposed upper surfaces of the structure 10. More specifically, the spacer layer may cover upper surface areas of the intermediate layer structure 16 exposed in the gaps between the first material lines 22, the sidewalls of the first material lines 22, and the sidewalls and the upper surfaces of the mandrel lines 20. The spacer layer may subsequently be subjected to an anisotropic etch (e.g. a vertically biased dry etch) adapted to remove spacer layer portions from horizontally oriented surfaces (e.g. upper surfaces of the mandrel lines 20 and the upper surface areas of the intermediate layer structure 16) such that spacer lines 24 remain on vertically oriented sidewalls.

The spacer material (of the spacer lines 24) may for example be formed of an oxide material (e.g. SiO₂), but may more generally be formed of materials listed as examples of the first material above provided it may be deposited as a conformal layer (e.g. by ALD) and is different from the first material such that the first material lines 22 and the spacer lines 24 may be etched selectively with respect to each other. Preferably, the spacer material should also be different from the material forming the upper surface of the intermediate layer structure 16.

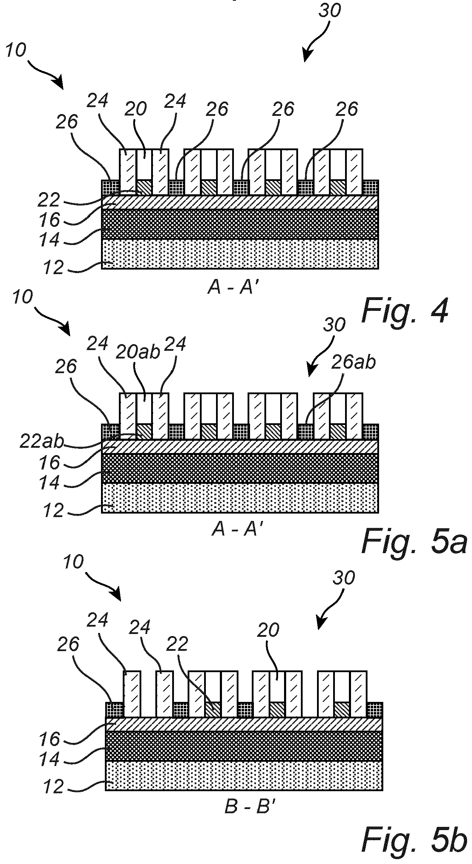

With reference to figure 4, a second set of material lines 26 have been formed on the intermediate layer structure 16. The second set of material lines 26 (hereinafter "second material lines 26") is formed as a set of parallel material lines extending along the X-direction. The second material lines 26 are formed in the gaps between the spacer lines 24. The second material lines 26 are of a second material. The first and second material lines together define an alternating pattern of material lines, hereinafter referred to as the material line pattern 30. That is, the lines of the alternating pattern of material lines 30 are alternatingly of the first material (i.e. a line of the first material lines 22) and of the second material (i.e. a line of the second material lines 26). Although the first material lines 22, the spacer lines 24 and the second material lines 26 are shown to be formed with matching/equal line widths other designs are possible, such as forming the first and second material lines 22, 26 with equal line widths and spacer lines with a different line width, such as a smaller line width.

The second material lines 26 may be formed by depositing a second material to form a second material layer over the mandrel lines 20 and the first material lines 22, and in the gaps between the first material lines 22 (and between the mandrel lines 20). A thickness of the second material layer may subsequently be reduced (e.g. by etch back optionally preceded by a polishing step to planarize the second material layer) such that discrete lines of the second material are formed in the gaps between the first material lines 22, thereby defining the second material lines 26 as depicted in figure 4. The second material layer may for instance be formed by spin-on-deposition, CVD or ALD. The second material may be formed of any of the materials listed as examples of the first material, however selected to be different from the first material. The second material should also be different from the spacer material such that the second material lines 26 and the spacer lines 24 may be etched selectively with respect to each other. Preferably, the second material should also be different from the material forming the upper surface of the intermediate layer structure 16. As a further example, the second material may be deposited by area selective deposition, using an upper surface of the intermediate layer structure 16 as a seeding surface, for instance using a metal-on-metal deposition process. Area selective deposition may obviate the need for polishing and/or etch back in that the second material may directly be deposited with a desired thickness in the gaps.

Figures 5a through 5c illustrate an optional line cutting process, for cutting of a line of the first material lines 22 and/or of a line of the second material lines 26.

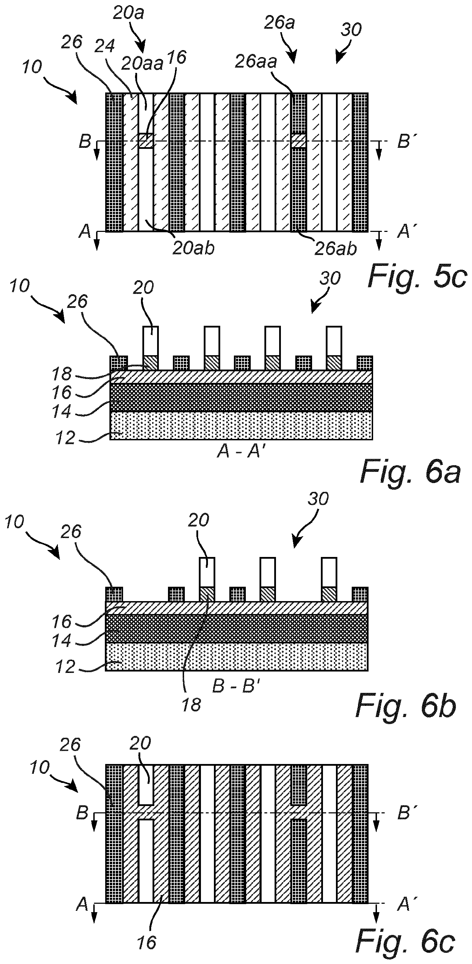

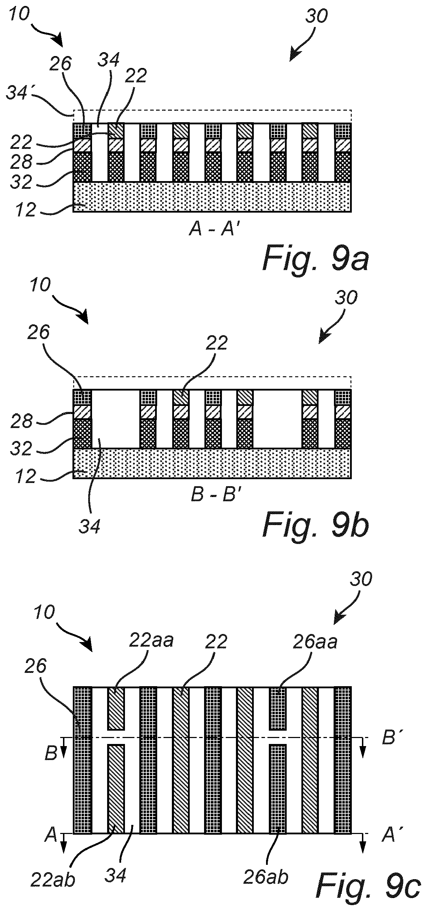

Figure 5a and figure 5b are cross-sectional views taken along the lines A-A' and B-B' indicated in the top-down view of figure 5c. As shown in figures 5b and 5c, a mandrel line 20a and an underlying material line 22a of the first material lines 22 may be cut into two line segments 20aa, 20ab and 22aa, 22ab, respectively. The line segments 20aa, 20ab and 22aa, 22ab, respectively, are separated by a gap exposing an upper surface of the intermediate layer structure 16. The material lines 22a are in figure 5c obscured by the mandrel lines 20a but may be seen in figure 9c. Additionally, or alternatively, a material line 26a of the second material lines 26 may be cut into two line segments 26aa, 26ab. The line segments 26aa, 26ab are separated by a gap exposing an upper surface of the intermediate layer structure 16. As may be appreciated, the effect of cutting a line is that during a subsequent patterning of the conductive layer 14 (described below) the cut or gap will be transferred into the conductive layer 14 in the sense that a conductive line with a corresponding cut or gap will form during the etching of the conductive layer 14.

The line cutting operation may be achieved by a litho-etch process. The cutting of the material line 22a of the first mandrel lines 22 may comprise forming a cut mask (which already has been removed at the stage of the process depicted in figures 5a-c) over the first and second material lines 22, 26 and the spacer lines 24. The cut mask may define a cut opening above the material line (and the above mandrel line) which is to be cut (e.g. material line 22a and mandrel line 20a and/or material line 26a), at the position where the cut is to be formed (e.g. along line B-B'). The mandrel line 20a and the material line 22a of the first material lines 22 may be cut by etching the material line 22a via the cut opening in the cut mask. Since the spacer lines 24 formed along the material line 22a is formed of the spacer material which is different from the first material, the etching may etch the material line 22a selective to the spacer lines 24. Since also the second material lines 26 are of a material different from the first material (i.e. the second material), the etching may etch the material line 22a selective also to the second material lines 26. Accordingly, if the cut opening (by choice or error e.g. due to EPE) overlaps an adjacent spacer line 26, the material line 22a may still be cut without cutting of the adjacent spacer line 24. Additionally, if the cut opening (by choice or error e.g. due to EPE) also overlaps a second material line 26, the material line 22a may still be cut without cutting of said second material line 26. This discussion applies correspondingly to the selective etching of the second material line 26a. The number of cuts shown in figures 5a-c is merely exemplary and it should be understood that any number of the first and second material lines 22, 26, even zero, may be subjected to line cutting.

With reference to figures 6a through 6c, the spacer lines 24 have been removed (i.e. "pulled") from the structure 10. Accordingly, the first and second material lines 22, 26 (cut or uncut) of the material line pattern 30 remain on the intermediate structure 16. As a result, the first and second material lines 22 of the material line pattern 30, previously regularly spaced apart by the spacer lines 26, are spaced apart by gaps. As shown, the gaps between the lines of the material line pattern 30 may reveal the upper surface of the intermediate layer structure 16. The spacer lines 24 may be removed by etching the spacer lines 24 selectively to the first and second material lines 22, 26. Any suitable wet or dry etching process may be used.

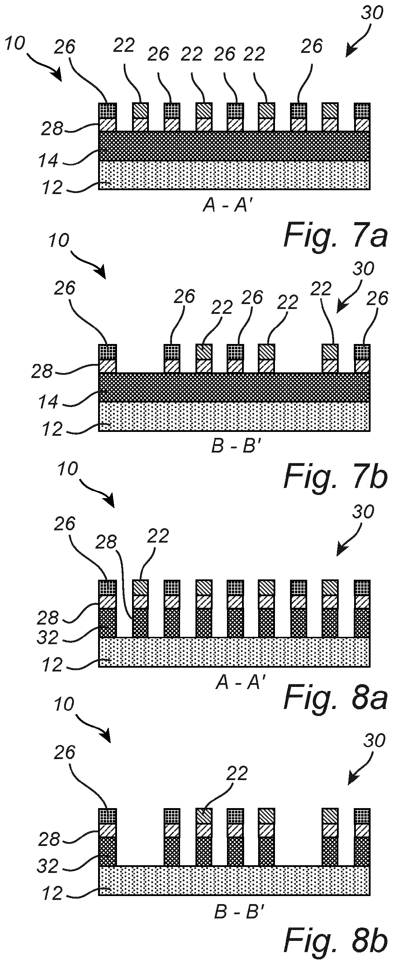

Figures 7-8 show how the conductive layer 14 may be patterned to form a set of conductive lines 32 by first etching the intermediate layer structure 16 and then proceeding with etching the conductive layer 14, while using the material line pattern 30 as an etch mask. Figures 7a and 8a show the structure 10 along the line A-A' while figures 7b, and 8b show the structure 10 along the line B-B'. The pattern defined by the material line pattern 30 has accordingly been transferred into the conductive layer 14. Accordingly, the conductive lines 32 may (like the lines of the material line pattern 30) be formed as a set of parallel lines extending along the X-direction and spaced apart by gaps. An upper surface of a layer on which the conductive layer 14 is formed (e.g. the insulating layer 12 or an interfacial layer if present as discussed above) may be exposed in the gaps. The etching of the intermediate layer structure 16 results in formation of corresponding intermediate lines 28 on the conductive lines 32. Above, the material line pattern 30 remain as a capping. That is, each conductive line 32 is capped by a respective material line of the material line pattern 30 (and a respective intermediate line 28 in-between). The conductive layer 14 and the intermediate layer structure 16 may for instance be etched using a RIE process, or some other conventional etching process enabling high fidelity pattern transfer into a conductive (e.g. metal) layer.

As shown in figures 7a, 7b, the mandrel lines 20 may be removed from the first material lines 22 prior to patterning the conductive layer 14. However, it is contemplated that the mandrel lines 20 also may remain on the material lines 22 wherein the material line pattern 30 and the mandrel lines 20 may act as a combined etch mask during the etching of at least the intermediate layer structure 16, and possibly also during the etching of the conductive layer 14.

With reference to figures 9a through 9c, an insulating material, different from the first and second materials, has been deposited over the structure 10. More specifically, insulating material has been deposited to form an initial insulating layer 34' filling the gaps between the capped conductive lines 32 and covering the material line pattern 30. The insulating material may for be formed in a same manner and of any of the materials discussed in connection with the insulating layer 12, such as CVD deposited SiO₂. The initial insulating layer 34' may subsequently be subjected to a polishing process and/or etch back to form a final insulating layer 34 with a planar upper surface flush with upper surfaces of the material line pattern 30.

In the figures, the insulating layer 35 has been formed to completely fill the gaps between the capped conductive lines 32. However, the insulating material may also be deposited such that upper gap portions between the first and second material lines are filled with the insulating material while air gaps are formed in lower gap portions between the conductive lines. Processes for forming air gaps between conductive lines is per se known in the art and will therefore not be described in detail herein. As a non-limiting example, air gaps may be formed by depositing insulating material to "pinch-off" the upper gap portion to define the air gap in the lower gap portion. Air gaps may further reduce a capacitive coupling between closely spaced conductive lines. In any case, the insulating material may be deposited on either side of the material lines of the material line pattern 30 such that the material lines are embedded by/spaced apart by the deposited insulating material. As discussed earlier, a three-tone pattern "ACBC" may thus be formed, as is readily visible in the top-down view of figure 9c.

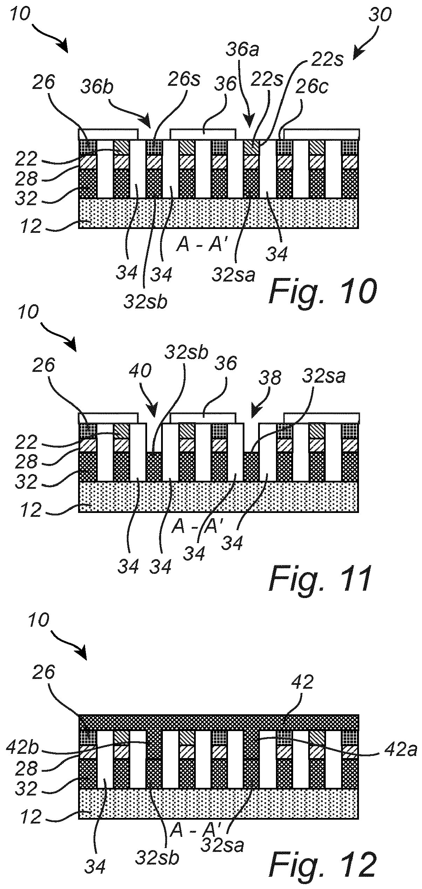

In figure 10, a via hole mask 36 has been formed over the material line pattern 30. The via hole mask 36 defines an opening 36a above a selected material line of the first material lines 22, for instance material line 22s. Additionally, or alternatively, the via hole mask 36 defines an opening 36b above a selected material line of the second material lines 26, for instance material line 26s. That an opening in the via hole mask 36 is defined above a selected material line hereby means that it is aligned with the selected material line, as viewed along the vertical direction. In other words, the opening overlaps the selected material 22s, 26s line such that the selected material line 22s, 26s may be etched through/via the opening 36a, 36b. The number of via openings shown in figure 10 is merely exemplary and it should be understood that any number of openings may be defined, in accordance with the number of vias that are to be formed.

As exemplified in figure 10 the openings 36a, 36b may be formed with a lateral dimension/width exceeding a line width of the selected material lines 22s, 26s. For instance, the opening 36b overlaps in addition to the selected material line 26s regions/areas of the insulating layer 34 adjacent thereto. The opening 36a overlaps in addition to the selected material line 22s regions/areas of the insulating layer 34 adjacent thereto and further a (non-selected) second material line 26c. Due to the three-tone-pattern defined by the material line pattern 30 and the insulating material of the insulating layer 34, and a selective etching of the selected material lines 22s, 26s, this need however not result in undesirable opening of the insulating layer 34 or of a non-selected line. Rather the via holes 38, 40 may be formed in a self-aligned manner with respect to the selected material lines 22s, 26s. Since the selected material lines 22s, 26s form a capping on respective ones of the conductive lines 32, the selection of material lines 22s, 26s to open by extension implies a selection of the (underlying) conductive lines 32sa, 32sb. This is illustrated in figure 11 showing that via holes 38, 40 have been formed and the conductive lines 32sa, 32sb capped by the selected material lines 22s, 26s have been exposed. A width of an opening may even (intentionally) be formed with a width such that the opening overlaps two or more first material lines 22 or second material lines 26. Two or more via holes may hence be formed in parallel, self-aligned to the selected (two or more) first or second material lines 22, 26, and accordingly self-aligned to the two or more selected conductive lines 32.

Forming of the via holes 38, 40 may comprise first opening the selected material line 22s by etching through the opening 36a, 36b and then opening the intermediate lines 28 by further etching though the opening 36a, 36b until an upper surface of the conductive lines 32sa, 32sb is exposed. As may be appreciated, the sidewalls of the via hole 38 may comprise portions formed by the insulating material (of the insulating layer 34) on either side of the selected material line 22s and by the first material (of the selected material line 22s), and material of the intermediate line 28. The sidewalls of the via hole 40 may comprise portions formed by the insulating material (of the insulating layer 34) on either side of the selected material line 26s and by the second material (of the selected material line 26s), and material of the intermediate line 28. The via holes 38 may be etched using a suitable dry etching process.

The via holes 38, 40 may be formed in a litho-etch sequence, as generally described above. For instance, the via hole mask 36 may be a photoresist layer wherein the openings 36a, 36b may be defined by lithography. Alternatively, the via hole mask 36 may be formed by a litho-stack wherein the openings in the via hole mask 36 may be transferred from the photoresist layer into lower layers of the litho-stack, and eventually into the selected material lines 22s, 26s and underlying intermediate line 28. The via holes 38, 40 may for a example be formed with a rounded (e.g. circular or oval) cross-sectional shape.

With reference to figure 12, the method proceeds by depositing a conductive material in the via holes 38, 40 to form a conductive via 42a, 42b. The vias 42a, 42b lands on the upper surfaces of the respective selected conductive lines 32sa, 32sb exposed during the preceding via hole formation shown in figure 11. The conductive material may be chosen from any of the examples mentioned in connection with the conductive layer 14, for example Ru. The conductive material may as shown in figure 12 be deposited to form a (second) conductive layer 42, covering the insulating layer 34 and filling the via holes 38, 40.

Accordingly, at the stage of the process shown in figure 12 a set of conductive lines 32 have been formed by a "direct" conductive layer (e.g. metal) etch and vias 38, 40 have thereafter been formed in a self-aligned manner on selected ones of the conductive lines 32. It may be noted that the pattern of material lines 30 remain in the device structure 10, embedded in the insulating layer 34 and the conductive layer 42. The pattern of material lines 30 may hence remain in the final interconnect structure.

The method may for example proceed with patterning the conductive layer 42, to form a further set of conductive lines. The conductive layer 42 may be patterned by forming a further mask of material lines (e.g. using a process similar to the process for forming the material line pattern 30, or some other patterning technique such as SADP, SAQP or EUVL), and etching the conductive layer 42 using the further mask as an etch mask. The mask may be aligned with the underlying structure 10 such that a respective mask line of the mask overlaps each via 38, 40. Thereby, conductive lines of the further set of conductive lines may be connected to conductive lines of the set of conductive lines 32 by means of the vias 38, 40. Further vias may be formed on selected ones of the further set of conductive lines, advantageously employing the above-described processing. Alternatively, the conventional dual damascene processing may be employed, depending on desired aggressiveness of pitch.

In the above the inventive concept has mainly been described with reference to a limited number of examples. However, as is readily appreciated by a person skilled in the art, other examples than the ones disclosed above are equally possible within the scope of the inventive concept, as defined by the appended claims. For instance, although in the above described method a common via hole mask 36 is used for forming via holes extending through both first and second material lines 22, 26 it is possible to use a first via hole mask for forming via holes through the first material lines 22, and (after stripping the first via hole mask) another second via hole mask for forming via holes through the first material lines 26, or vice versa.

Furthermore, the structure 10 comprises the intermediate layer structure 16, located between the conductive layer 14 and the material line pattern 30. It is however also possible to omit the intermediate layer structure 16 and thus form the material line pattern 30 in contact with the conductive layer 14. For example, the first material layer 18 may be formed on the upper surface of the conductive layer 14 and subsequently be patterned to form the first set of material lines 22 in the manner set out in connection with figures 1-2. The method may thereafter proceed as discussed in connection with the further figures, however ignoring any reference to the intermediate layer structure 16 and intermediate lines 28.

## Claims

1. A method for forming an interconnection structure for a semiconductor device, the method comprising:
forming, over a conductive layer (14), an alternating pattern of parallel material lines (30) of a first set of material lines (22) of a first material and of a second set of material lines (26) of a second material, the material lines being spaced apart by gaps,
patterning the conductive layer (14), the patterning comprising etching while using the alternating pattern of material lines (30) as an etch mask, thereby forming a set of parallel conductive lines (32) spaced apart by gaps and capped by the alternating pattern of material lines (30),
depositing an insulating material (34) different from the first and second materials between the set of capped conductive lines (32, 30), and
forming a via hole mask (36) defining an opening (36a, 36b) above a selected material line (22s, 26s) of either the first or second set of material lines (22, 26),
forming a via hole (38, 40) exposing the conductive line (32sa, 32sb) capped by said selected material line (22s, 26s), the forming of the via hole (38, 40) comprising selectively etching said selected material line (22s, 26s) through the opening (36a, 36b) in the via hole mask (36), and
depositing a conductive material (42) in the via hole (38, 40) to form a conductive via (42a, 42b) on said conductive line (32sa, 32sb) capped by said selected material line (22s, 26s).

2. A method according to claim 1, wherein an intermediate layer structure (16) of one or more layers is formed on the conductive layer (14), and wherein the alternating pattern of material lines (30) is formed on an upper surface (16') of the intermediate layer structure (16), wherein said patterning of the conductive layer (14) comprises first etching the intermediate layer structure (16) and then etching the conductive layer (14), and wherein said forming of the via hole (38, 40) comprises first etching said selected material line (22s, 26s) and then etching the intermediate layer structure (16).

3. A method according to any preceding claim, further comprising:
forming spacer lines (24) on and along sidewalls of the first material lines (22), wherein forming the second material lines (26) comprises depositing the second material in gaps between the spacer lines (24), and
subsequent to forming the second material lines (26), removing the spacer lines (24) between the first and second material lines (22, 26).

4. A method according to any preceding claim, wherein forming the first set of material lines (22) comprises:
forming a first material layer (18),
forming a set of mandrel lines (20) over the first material layer (18), and
patterning the first material layer (18) to form the first set of material lines (22), the patterning comprising etching while using the set of mandrel lines (20) as an etch mask.

5. A method according to claim 4, wherein spacer lines (24) are formed subsequent to patterning the first material layer (18), on and along sidewalls of the first material lines (22).

6. A method according to any of claims 4-5, further comprising removing the set of mandrels (20) prior to depositing the insulting material (34).

7. A method according to any preceding claim, wherein the insulating material (34) is deposited to cover the first and second material lines (22, 26), and the method further comprises, by polishing process and/or etch back, forming an insulting layer (35) with a planar upper surface (35') flush with upper surfaces (22', 26') of the first and second material lines (22, 26).

8. A method according to any preceding claim, further comprising depositing a conductive material to form a second conductive layer (42), the conductive material covering the insulating layer and filling the via hole.

9. A method according to any preceding claim, wherein the opening (36a, 36b) in the via hole mask (36) further extends above the deposited insulating material in a region adjacent to the selected material line (22s, 26s).

10. A method according to claim 9, wherein the opening (36a, 36b) in the via hole mask (36) further extends above a consecutive material line (22n, 26n) of the alternating pattern of material lines.
